Europäisches Patentamt

European Patent Office

Office européen des brevets

(19)

(11) EP 0 825 613 A2

## (12) EUROPÄISCHE PATENTANMELDUNG

(43) Veröffentlichungstag:
25.02.1998 Patentblatt 1998/09

(51) Int. Cl.$^6$: G11C 17/12

(21) Anmeldenummer: 97110309.8

(22) Anmeldetag: 24.06.1997

(84) Benannte Vertragsstaaten:
AT BE CH DE DK ES FI FR GB GR IE IT LI LU MC NL PT SE
Benannte Erstreckungsstaaten:
AL LT LV RO SI

(30) Priorität: 01.08.1996 DE 19631169

(71) Anmelder:
SIEMENS AKTIENGESELLSCHAFT
80333 München (DE)

(72) Erfinder:
• Thewes, Roland
  82194 Gröbenzell (DE)
• von Basse, Paul-Werner
  82515 Wolfratshausen (DE)
• Bollu, Michael
  81671 München (DE)
• Schmitt-Landsiedel, Doris
  85521 Ottobrunn (DE)

(54) **Matrix-Speicher in Virtual-ground-Architektur**

(57) Matrix-Speicher mit verbesserter Virtual-ground-Architektur und Auswerteschaltung, aus dem während eines Lesevorgangs über eine Bitleitung gleichzeitig der Informationsgehalt zweier benachbarter Speicherzellen ($Z_{n,k}$) ausgelesen werden kann. Die Speicherzellen mit Information „0" sind z. B. durch je einen Feldeffekttransistor mit niedriger Schwellenspannung realisiert. Jede für das Auslesen vorgesehene Bitleitung ($BL_n$) ist mit den Drain-Anschlüssen zweier in derselben Zeile benachbarter FETs verbunden. Die Source-Anschlüsse werden auf je eines von zwei voneinander verschiedenen Potentialen gelegt. Je nachdem, welche der FETs bei Auswahl der betreffenden Wortleitung leiten, erhält man auf der Bitleitung unterschiedliche resultierende Potentiale, die in der Auswerteschaltung in Binär-Signale, die die gelesenen Informationen repräsentieren, umgewandelt werden.

FIG 1

EP 0 825 613 A2

**Beschreibung**

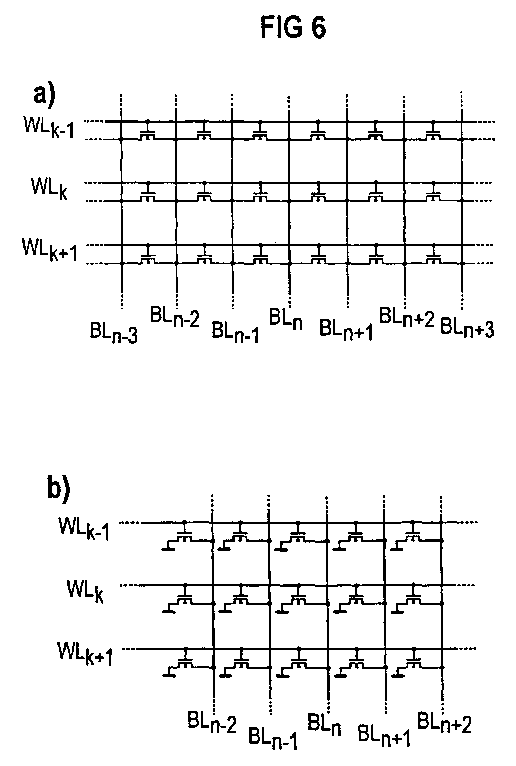

Der Flächenbedarf von Speicherzellenfeldern in ROM-Strukturen ist bestimmt durch die Größe der eigentlichen Speicherzelle, die z. B. als maskenprogrammierter Transistor, als Floating-Gate-Zelle o. dgl. ausgeführt sein kann, und durch den Platzbedarf der Zuleitungen zu den Speicherzellen. Um bei vorgegebener Zellengröße eine Erhöhung der Speicherkapazität pro Chipfläche zu erzielen, muß der Flächenbedarf der Zuleitungen reduziert werden. Man erreicht das durch die sogenannte Virtual-ground-Architektur des Zellenfeldes, wie sie z. B. in den Veröffentlichungen von B. Eitan et al. in IEEE Electron Device Letters 12, 450 - 452 (1991), in IEDM 91, 311 - 314 (1991) und in 1993 VLSITSA, 336 - 338 (1993) beschrieben ist. Bei dieser Anordnung liegen wie im Schema in der beigefügten Figur 6a dargestellt die Speichertransistoren mit ihren Source- und Drain-Anschlüssen an gemeinsam genutzten Bitleitungen ($BL_n$). In konventionellen Anordnungen entsprechend dem Schema in Figur 6b liegt der Drain-Anschluß an einer Bitleitung, der Source-Anschluß aber auf Masse. Die Geschwindigkeit des Lesevorgangs ist abgesehen von anderen Faktoren wesentlich durch die innerhalb des Speicherzellenfeldes erfolgende Ansteuerung und die dafür maßgeblichen Zeitkonstanten bestimmt. Die Dauer für einen Lesezugriff ist einer der wichtigsten Parameter, die die Eigenschaften eines Speichers charakterisieren. Um die Lesegeschwindigkeit zu erhöhen, wurden bisher vorwiegend solche Maßnahmen getroffen, die parasitäre Kapazitäten und Widerstände der Speicherzellen verringern oder die Stromtreibfähigkeit der Speichertransistoren erhöhen.

Aufgabe der vorliegenden Erfindung ist es, einen Matrix-Speicher anzugeben, der eine prinzipielle Verkürzung der Dauer der Lesevorgänge ermöglicht.

Diese Aufgabe wird mit dem Matrix-Speicher mit den Merkmalen des Anspruches 1 gelöst. Weitere Ausgestaltungen ergeben sich aus den abhängigen Ansprüchen.

Bei dem erfindungsgemäßen Matrix-Speicher ist eine Ausleseschaltung vorgesehen, die es ermöglicht, während eines Lesevorgangs über eine Bitleitung gleichzeitig den Informationsgehalt zweier benachbarter Speicherzellen auszuwerten. Dabei stellt die Bitleitung, über die ausgelesen wird, den gemeinsamen Knoten der beiden betreffenden Speicherzellen an einer ausgewählten Wortleitung dar. Die Speicherzellen sind so konzipiert, daß sie bei Auswahl der zugehörigen Wortleitung leitend werden je nachdem, ob eine logische „0" oder „1" in der Zelle gespeichert ist. Welchen Zustand man als „0" oder als „1" auffaßt, ist grundsätzlich freigestellt. In den nachfolgenden Erläuterungen und in den Ansprüchen wird einer Zelle, die bei Anlegen eines geeigneten Potentials über die zugehörige Wortleitung leitend wird, die Information „0" beigelegt.

Eine solche Zelle ist im Prinzip durch einen steuerbaren Widerstand, wie er z. B. durch einen Feldeffekttransistor realisiert wird, gegeben. Eine zwischen einem ersten und einem zweiten Anschluß dieses Widerstandes vorhandene Potentialdifferenz gleicht sich aus, falls bei Anlegen eines geeigneten Potentials an einen dritten Anschluß der Wert dieses Widerstandes in ausreichendem Maß verringert wird. Falls in einer Zelle kein solcher Widerstand vorhanden ist oder sich der Wert dieses Widerstandes nicht oder nicht in ausreichendem Maß verringert, bleibt eine an dem ersten und dem zweiten Anschluß anliegende Potentialdifferenz zumindest während der für einen Lesevorgang vorgesehenen Zeitdauer erhalten. Die Information der Zelle ist dann der hier vorgenommenen Einteilung entsprechend eine „1". Wenn eine für das Auslesen vorgesehene Bitleitung mit den ersten Anschlüssen zweier in derselben Zeile benachbarter solcher Widerstände verbunden ist und die jeweils zweiten Anschlüsse dieser Widerstände auf je einem von zwei voneinander verschiedenen Potentialen liegen, erhält man bei Auswahl der zu diesen beiden Widerständen führenden Wortleitung je nach den darin vorhandenen Informationen unterschiedliche resultierende Potentiale auf der Bitleitung. Das jeweilige Potential auf dieser Bitleitung gibt daher die Information zweier Speicherzellen gleichzeitig.

Eine genauere Erläuterung zu dem Aufbau und der Funktionsweise des erfindungsgemäßen Matrix-Speichers folgt anhand der beigefügten Figuren 1 bis 6.

Figur 1 zeigt das Schema eines bevorzugten Ausführungsbeispiels.
Figuren 2 und 3 zeigen Diagramme zur Bestimmung eines in der Schaltung auftretenden Potentials.
Figuren 4 und 5 zeigen Auswerteschaltungen im Schema.
Figuren 6a und 6b zeigen die eingangs erläuterten Anordnungen aus dem Stand der Technik.

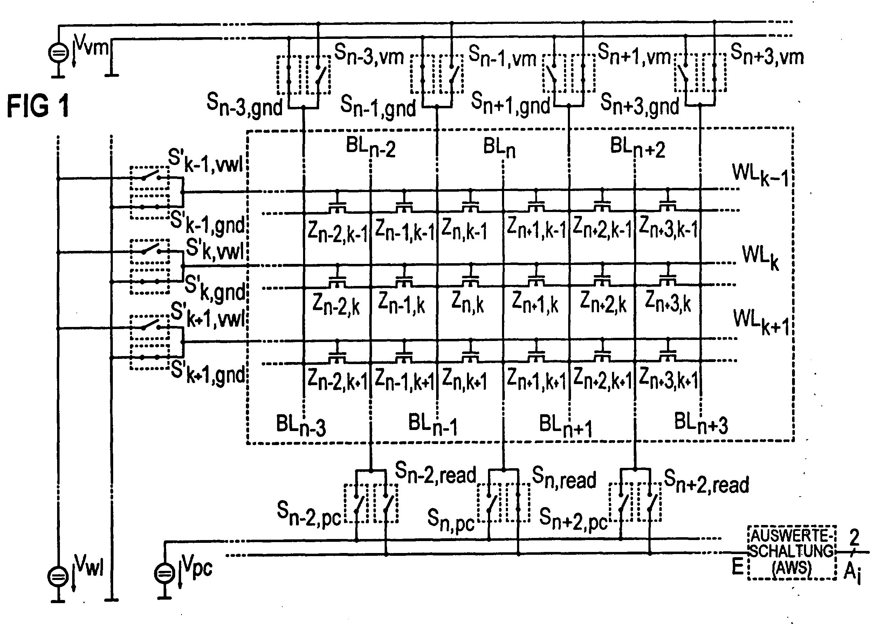

Bei der Anordnung der Speicherzellen in Figur 1 sind die Spalten der Anordnung von links nach rechts und die Zeilen der Anordnung von oben nach unten aufsteigend numeriert. Eine solche Numerierung kann ansonsten mit einer beliebigen Zahl und auf einer beliebigen Seite des Speicherzellenfeldes beginnen. Die Speicherzellen sind in der Form $Z_{n,k}$ bezeichnet, wobei der erste Index ($_n$) die Nummer der Spalte bzw. einer benachbarten Bitleitung $BL_n$ und der zweite Index ($_k$) die Nummer der Zeile bzw. einer benachbarten Wortleitung $WL_k$ bezeichnet. Die Informationen der in einer Zeile benachbarten Speicherzellen $Z_{n,k}$ und $Z_{n+1,k}$ sollen über die gemeinsame Bitleitung $BL_n$ gelesen werden. Die Information der Speicherzelle soll einer logischen „1" entsprechen, falls kein Speichertransistor vorhanden ist oder ein vorhandener Feldeffekttransistor eine sehr hohe, über dem (hier positiven) Betriebspotential $V_{DD}$ der Schaltung liegende Schwellenspannung aufweist. Die Information der Speicherzelle soll einer logischen „0" entsprechen, falls ein

2

Feldeffekttransistor überhaupt vorhanden ist oder im Unterschied zu den übrigen Transistoren eine niedrige Schwellenspannung aufweist. Die ersten genannten Möglichkeiten betreffen z. B. maskenprogrammierte ROMs, die zweiten Möglichkeiten z. B. EPROMs und Abarten maskenprogrammierter ROMs. Bei dem in Figur 1 gezeigten Ausführungsbeispiel ist die jeweils zweite Möglichkeit realisiert.

Der Informationsinhalt der Speicherzelle $Z_{n,k}$ wird im folgenden mit der zugehörigen booleschen Variablen $z_{n,k}$ bezeichnet, die den Wert 0 oder 1 besitzt. In dem zu beschreibenden Ausführungsbeispiel soll eine „1" durch ein hohes Potential repräsentiert werden, das hier identisch mit dem positiven Betriebspotential $V_{DD}$ der gesamten Schaltung ist. Die „0" soll durch ein niedriges Potential repräsentiert werden, das hier identisch mit dem Massepotential $V_{gnd}$ der gesamten Schaltung ist.

Wenn die Informationsinhalte der Speicherzellen $Z_{n,k}$ und $Z_{n+1,k}$ der Anordnung der Figur 1 für ein bestimmtes n und ein bestimmtes k ausgelesen werden sollen, wird die diesen Zellen gemeinsame Bitleitung $BL_n$ auf das Potential $V_{pc}$ vorgeladen. Dieses Potential $V_{pc}$ ist das Drain-Potential bei Verwendung von n-Kanal-MOSFETs in den Zellen. Welche Werte für dieses Potential in Frage kommen, ergibt sich aus der nachfolgenden Erläuterung des Lesevorganges. In vielen Fällen ist es praktikabel, dieses Potential $V_{pc}$ gleich dem positiven Betriebspotential $V_{DD}$ zu wählen.

Für die Bitleitungen sind Schalter $S_n$ vorgesehen, mit denen die Bitleitungen in ihrer Folge alternierend mit dem Potential $V_{pc}$ oder im zeitlichen Wechsel mit einem von zwei verschiedenen niedrigeren Potentialen, hier als $V_{vm}$ und $V_{gnd}$ bezeichnet, verbunden werden können. Beim Vorladen der Bitleitung $BL_n$ (bestimmtes n) ist der Schalter $S_{n,pc}$ geschlossen, alle übrigen Schalter $S_{n+2m,pc}$ mit ganzzahligem m ungleich 0 sind geöffnet. Die Schalter $S_{n+2m,read}$ mit ganzzahligem m, die zum Weiterleiten der ausgelesenen Information für die Auswertung vorgesehen sind, sind ebenfalls geöffnet.

Der Source-Anschluß des Transistors in Zelle $Z_{n,k}$ wird über den Schalter $S_{n-1,gnd}$ und die Bitleitung $BL_{n-1}$ mit dem Potential $V_{gnd}$ verbunden; der Source-Anschluß des Transistors in Zelle $Z_{n+1,k}$ wird über den Schalter $S_{n+1,vm}$ und die Bitleitung $BL_{n+1}$ mit dem Potential $V_{vm}$ verbunden. Die übrigen Schalter $S_{n+1+2m,gnd}$ mit ganzzahligem m ungleich -1 und die übrigen Schalter $S_{n+1+2m,vm}$ mit ganzzahligem m ungleich 0 sind z. B. geöffnet. Aus Gründen eines möglichst einfachen Algorithmus zur Ansteuerung des Speicherzellenfeldes und aus Gründen der Verlustleistungsbilanz ist es sinnvoll, alle Bitleitungen $BL_{n-1-2m}$ mit m = 0, 1, 2, 3, 4,... über die Schalter $S_{n-1-2m,gnd}$ mit m = 0, 1, 2, 3, 4,... mit $V_{gnd}$ zu verbinden und alle Bitleitungen $BL_{n+1+2m}$ mit m = 0, 1, 2, 3, 4,... über die Schalter $S_{n+1+2m,vm}$ mit m = 0, 1, 2, 3, 4,... mit $V_{vm}$ zu verbinden, wie es in Figur 1 dargestellt ist. Für das Auslesen der Zellen $Z_{n,k}$ und $Z_{n+1,k}$ ist aber nur wichtig, daß die Source-Anschlüsse der Transistoren dieser Zellen mit $V_{gnd}$ bzw. mit $V_{vm}$ verbunden sind, wobei diese Potentiale auch vertauscht sein können.

Das Potential $V_{vm}$ liegt vorzugsweise zwischen $V_{gnd}$ und $V_{DD}$. Bevorzugte Werte ergeben sich für $V_{vm} = V_{gnd} + \alpha(V_{DD} - V_{gnd})$ mit $\alpha$ mindestens 0,3 und höchstens 0,6. Das Potential $V_{vm}$ ist niedriger als das zum Vorladen der Bitleitungen angelegte Potential $V_{pc}$.

Es sind Schalter $S'_{k,gnd}$ und $S'_{k,vwl}$ vorgesehen, mit denen die Wortleitungen $WL_k$ jeweils mit dem Potential $V_{gnd}$ oder dem Potential $V_{wl}$ verbunden werden können. Während des Vorladens der Bitleitung $BL_n$ sind z. B. alle Schalter $S'_{k,gnd}$ geschlossen und alle Schalter $S'_{k,vwl}$ offen, so daß alle Wortleitungen auf Massepotential $V_{gnd}$ liegen. Nachdem die Bitleitung vorgeladen ist, werden die Schalter $S_{n,pc}$ und $S'_{k,gnd}$ mit dem bestimmten k der auszulesenden Zellen geöffnet und die Schalter $S_{n,read}$ mit dem bestimmten n der auszulesenden Zellen und $S'_{k,vwl}$ mit dem bestimmten k der auszulesenden Zellen geschlossen. Die Gate-Anschlüsse der Transistoren in den auszulesenden Speicherzellen $Z_{n,k}$ und $Z_{n+1,k}$ liegen somit an dem Potential $V_{wl}$, das vorzugsweise gleich dem (hier positiven) Betriebspotential $V_{DD}$ ist. Um die Transistoren in den Zellen mit einer „0" leitend zu machen, ist das Potential $V_{wl}$ mindestens im Abstand der Schwellenspannung der betreffenden Transistoren von beiden Potentialen $V_{gnd}$ und $V_{vm}$ entfernt (hier $V_{wl}>V_{vm}+V_{th,0}$, wobei $V_{th,0}$ die Schwellenspannung der Transistoren ist, die eine logische „0" repräsentieren). In Abhängigkeit von der Tatsache, ob in den Zellen $Z_{n,k}$ und $Z_{n+1,k}$ Transistoren vorhanden sind bzw. ob die Transistoren eine niedrige Schwellenspannung aufweisen, stellt sich auf der Bitleitung $BL_n$ ein bestimmtes Potential ein. Für dieses Potential kommen vier verschiedene Werte $V_{BL}(z_{n,k},z_{n+1,k})$ in Frage, je nachdem, ob $z_{n,k}$ und $z_{n+1,k}$ 0 oder 1 sind.

a) Falls $z_{n,k} = z_{n+1,k} = 1$ ist, bleibt $BL_n$ auf dem Potential $V_{pc}$, also $V_{BL}(1,1) = V_{pc}$. Es ist in beiden Zellen $Z_{n,k}$ und $Z_{n+1,k}$ kein (zwischen Source und Drain) leitender Transistor vorhanden, so daß kein Ausgleich der Potentialdifferenz zwischen der Bitleitung $BL_n$ und den Bitleitungen $BL_{n-1}$ bzw. $BL_{n+1}$ stattfinden kann.

b) Falls $z_{n,k} = 0$ und $z_{n+1,k} = 1$ ist, ist der Transistor in Zelle $Z_{n,k}$ leitend, und die Bitleitung $BL_n$ wird bis auf das Potential $V_{gnd}$, das am Source-Anschluß des Transistors in der Zelle $Z_{n,k}$ anliegt, entladen, also $V_{BL}(0,1) = V_{gnd}$.

c) Falls $z_{n,k} = 1$ und $z_{n+1,k} = 0$ ist, ist der Transistor in Zelle $Z_{n+1,k}$ leitend, und die Bitleitung $BL_n$ wird bis auf das Potential $V_{vm}$, das am Source-Anschluß des Transistors in der Zelle $Z_{n+1,k}$ anliegt, entladen, also $V_{BL}(1,0) = V_{vm}$.

d) Falls $z_{n,k} = 0$ und $z_{n+1,k} = 0$ ist, sind die Transistoren in beiden Zellen $Z_{n,k}$ und $Z_{n+1,k}$ leitend, und die Bitleitung

$BL_n$ wird bis auf das Potential $V_{BL}(0,0)$, im folgenden und in den Ansprüchen als mittleres Potential bezeichnet, entladen. Dieses mittlere Potential kommt dadurch zustande, daß die leitenden Transistoren in den benachbarten Zellen einen Spannungsteiler bilden, so daß zwischen den Transistoren ein Potential zwischen $V_{vm}$ und $V_{gnd}$ vorhanden ist. Dieses mittlere Potential liegt nicht in der Mitte zwischen $V_{vm}$ und $V_{gnd}$, sondern etwas unterhalb von $0,5(V_{vm} + V_{gnd})$, da der Transistor, an dessen Source-Anschluß das höhere Potential anliegt (in diesem Beispiel das Potential $V_{vm}$ an dem Transistor in Zelle $Z_{n+1,k}$) mit einer niedrigeren Gate-Source-Spannung betrieben wird als der andere Transistor und daher einen etwas größeren Widerstand besitzt.

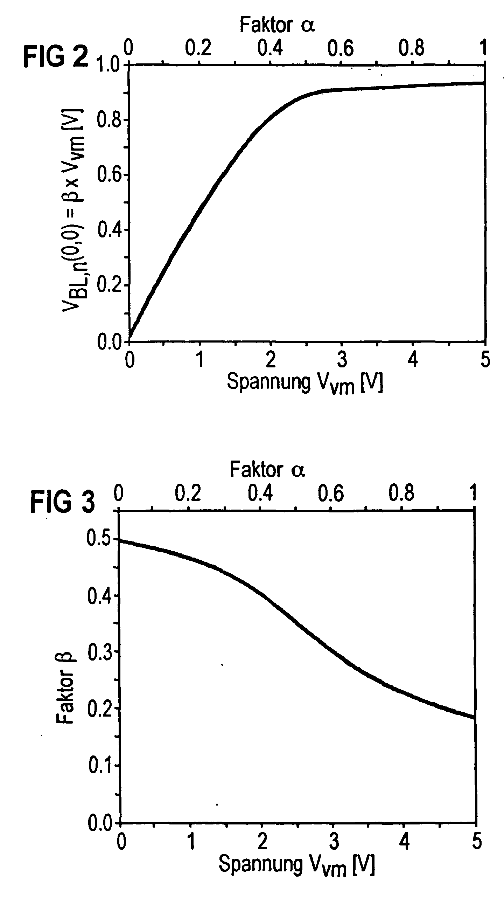

Für das beschriebene Ausführungsbeispiel ist in Figur 2 das mittlere Potential $V_{BL}(0,0) = V_{gnd} + \beta(V_{vm} - V_{gnd})$ als Funktion von $V_{vm}$ ($= V_{gnd} + \alpha(V_{DD} - V_{gnd})$) bzw. als Funktion von $\alpha$ in einem Diagramm aufgetragen für $V_{DD} = V_{wl} = V_{gnd} + 5\,V$ und zwei Transistoren mit einer Kanallange von 0,8 µm und einer Oxiddicke $t_{ox} = 20$ nm (Technologiedaten: 0,8 µm 5 V CMOS-Prozeß, $t_{ox} = 20$ nm).

Figur 3 zeigt den Faktor $\beta$ als Funktion von $V_{vm}$ ($= V_{gnd} + \alpha(V_{DD} - V_{gnd})$) bzw. als Funktion von $\alpha$ in einem Diagramm. Für $\alpha$ zwischen 0,3 und 0,6 liegt $\beta$ etwa zwischen 0,3 und 0,45.

Es gilt bei diesem Ausführungsbeispiel also speziell

$$V_{BL}(0,0) = V_{gnd} + \beta(V_{vm} - V_{gnd}) \text{ mit } \beta \text{ zwischen 0,3 und 0,45,}$$

$$V_{BL}(1,0) = V_{vm},$$

$$V_{BL}(0,1) = V_{gnd},$$

$$V_{BL}(1,1) = V_{pc}.$$

Etwas allgemeiner (bei Verwendung von n-Kanal-Feldeffekttransistoren und der hier vorgenommenen Zuordnung der „0" und der „1") gilt

$$V_{BL}(0,1) < V_{BL}(0,0) < V_{BL}(1,0) < V_{BL}(1,1)$$

oder bei anderer Wahl der Potentiale

$$V_{BL}(1,0) < V_{BL}(0,0) < V_{BL}(0,1) < V_{BL}(1,1).$$

Zu dem Zeitpunkt, an dem die Bewertung des schließlich an der auszulesende Bitleitung anliegenden Potentials $V_{BL}$ erfolgen soll, ist diese Bitleitung über den weiteren Schalter $S_{n,read}$ mit dem Eingang E einer Auswerteschaltung AWS verbunden, deren Aufgabe es ist, den Wert des Potentials in ein binäres 2-Bit-Signal an den Ausgängen $A_i$, i = 1, 2, umzusetzen.

Beim Anlegen des Potentials $V_{wl}$ an die Gate-Anschlüsse einer Zeile von Transistoren liegt an den Transistoren von Spalte zu Spalte abwechselnd eine kleinere Gate-Source-Spannung ($V_{wl} - V_{vm}$) und eine kleinere Drain-Source-Spannung ($V_{pc} - V_{vm}$) oder eine größere Gate-Source-Spannung ($V_{wl} - V_{gnd}$) und eine größere Drain-Source-Spannung ($V_{pc} - V_{gnd}$) an. Bei Verwendung gleichartiger Transistoren erfolgt daher der Ausgleich der größeren Potentialdifferenz zwischen Source und Drain bei einer höheren Gate-Source-Spannung und daher niedrigerem Widerstand. Das Entladen der jeweils für das Auslesen zweier Zellen ausgewählten Bitleitung erfolgt daher über einen leitenden Transistor in jeder der angrenzenden Spalten etwa gleich schnell. Sollen für eine weitergehende Optimierung die Transistoren zusätzlich an die unterschiedlichen verwendeten Potentiale angepaßt werden, können spaltenweise abwechselnd Feldeffekttransistoren mit etwas unterschiedlichen Eigenschaften, insbesondere unterschiedlichen Schwellenspannungen, eingesetzt werden. Beim Auslesen wird dann an die Source-Anschlüsse der Transistoren in einer geradzahlig numerierten Spalte jeweils ein bestimmtes vorgegebenes Potential (in dem beschriebenen Beispiel $V_{gnd}$ bzw. $V_{vm}$) angelegt, dessen Wert ausreichend niedrig ist, um beim Anliegen des Potentials $V_{wl}$ an den Gate-Anschlüssen diese Transistoren in den Zellen mit einer logischen „0" leitend zu machen. An die Source-Anschlüsse der Transistoren in einer ungeradzahlig numerierten Spalte wird jeweils ein bestimmtes anderes vorgegebenes Potential (in dem beschriebenen Beispiel $V_{vm}$ bzw. $V_{gnd}$) angelegt, dessen Wert ausreichend niedrig ist, um beim Anliegen des Potentials $V_{wl}$ an den Gate-Anschlüssen entsprechend diese Transistoren in den Zellen mit einer logischen „0" leitend zu machen.

Statt n-Kanal-Feldeffekttransistoren können p-Kanal-Feldeffekttransistoren verwendet werden. Die für das Auslesen von Zellen vorgesehene Bitleitung wird dann auf ein niedriges Potential vorgeladen. Die an die Source-Anschlüsse angelegten Potentiale sind spaltenweise alternierend verschieden und mindestens um die Schwellenspannung höher als das Gate-Potential $V_{wl}$ zum Auswählen einer Zeile. Die hier gemachten Angaben und die Definitionen der Merkmale in den Ansprüchen gelten auch bei Vertauschen des Vorzeichens der Schwellenspannung. Im Prinzip kommt es nur darauf an, daß in den Zellen (zumindest in denjenigen mit einer „0") steuerbare Widerstände vorhanden sind. Diese Widerstände ermöglichen einen ausreichenden Stromfluß zwischen einem ersten und einem zweiten Anschluß, falls ein Potential mit einem bestimmten Wert oder einem Wert in einem bestimmten Intervall an einem dritten Anschluß dieses Widerstandes anliegt. Andernfalls reduzieren oder sperren diese Widerstände den Stromfluß. Gegebenenfalls, wie im Fall der Feldeffekttransistoren, ist auch die Potentialdifferenz zwischen dem dritten Anschluß und einem der beiden anderen Anschlüsse des steuerbaren Widerstandes zu berücksichtigen.

Es genügt, wenn die in den Zellen eingesetzten steuerbaren Widerstände die folgenden Eigenschaften besitzen: Zu einer Numerierung der Spalten (von links nach rechts steigend oder fallend und mit einer beliebigen Zahl beginnend) sind

jeweils alle diejenigen dieser Widerstände, die in geradzahlig numerierten Spalten angeordnet sind, so beschaffen, daß bei Anlegen eines ersten vorgegebenen Potentials an den ersten Anschluß eines solchen Widerstandes, eines zweiten vorgegebenen Potentials an dessen zweiten Anschluß und eines dritten vorgegebenen Potentials an dessen dritten Anschluß dieser Widerstand zwischen diesem ersten und diesem zweiten Anschluß so niedrig ist, daß ein Ausgleich der Potentialdifferenz zwischen diesem ersten und diesem zweiten Anschluß innerhalb einer für einen Lesevorgang vorgesehenen Zeit erfolgt, und daß bei Anlegen dieses ersten vorgegebenen Potentials an diesen ersten Anschluß, dieses zweiten vorgegebenen Potentials an diesen zweiten Anschluß und eines vierten vorgegebenen Potentials an diesen dritten Anschluß dieser Widerstand zwischen diesem ersten und diesem zweiten Anschluß so hoch ist, daß die Potentialdifferenz zwischen diesem ersten Anschluß und diesem zweiten Anschluß während dieser für einen Lesevorgang vorgesehenen Zeit im wesentlichen erhalten bleibt, und

jeweils alle diejenigen dieser Widerstände, die in ungeradzahlig numerierten Spalten angeordnet sind, so beschaffen, daß bei Anlegen dieses ersten vorgegebenen Potentials an den ersten Anschluß eines solchen Widerstandes, eines von diesem zweiten vorgegebenen Potential verschiedenen fünften vorgegebenen Potentials an dessen zweiten Anschluß und dieses dritten vorgegebenen Potentials an dessen dritten Anschluß dieser Widerstand zwischen diesem ersten und diesem zweiten Anschluß so niedrig ist, daß ein Ausgleich der Potentialdifferenz zwischen diesem ersten und diesem zweiten Anschluß innerhalb einer für einen Lesevorgang vorgesehenen Zeit erfolgt, und daß bei Anlegen dieses ersten vorgegebenen Potentials an diesen ersten Anschluß, dieses fünften vorgegebenen Potentials an diesen zweiten Anschluß und dieses vierten vorgegebenen Potentials an diesen dritten Anschluß dieser Widerstand zwischen diesem ersten und diesem zweiten Anschluß so hoch ist, daß die Potentialdifferenz zwischen diesem ersten Anschluß und diesem zweiten Anschluß während dieser für einen Lesevorgang vorgesehenen Zeit im wesentlichen erhalten bleibt.

Es ist möglich, wie in dem Ausführungsbeispiel der Figur 1 nur jede zweite Bitleitung für das Auslesen vorzusehen. Die Schalter können statt dessen so eingerichtet sein, daß grundsätzlich jede vorhandene Bitleitung für das Auslesen zweier angrenzender Zellen ausgewählt, d. h. auf das erste vorgegebene Potential (im Beispiel $V_{pc}$) vorgeladen werden kann. Die dazu benachbarten Bitleitungen werden dann an das zweite Potential (im Beispiel $V_{gnd}$) bzw. an das fünfte Potential (im Beispiel $V_{vm}$) gelegt. Das setzt allerdings voraus, daß die steuerbaren Widerstände ausreichend symmetrisch sind, um die beschriebene Funktionsweise zwischen dem ersten und zweiten Anschluß in beiden Richtungen zu ermöglichen.

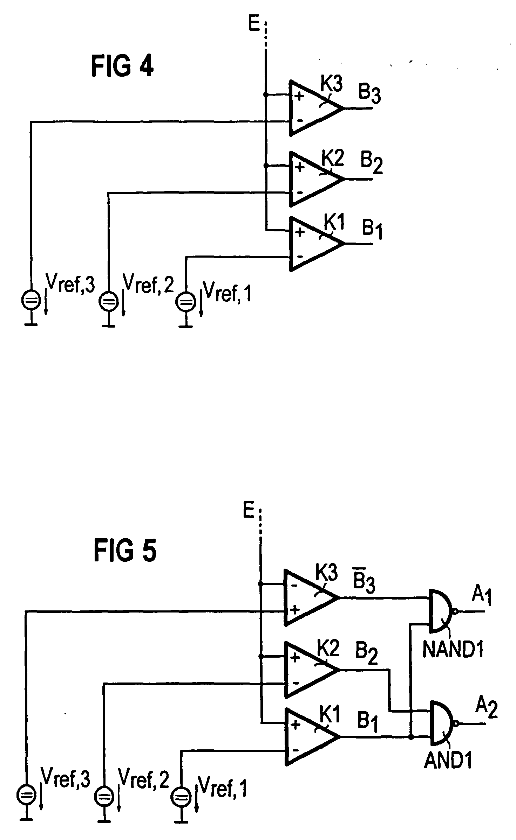

In den Figuren 4 und 5 sind im Schema Schaltungen dargestellt, mit denen die Auswerteschaltung AWS aufgebaut sein kann. Um das Ergebnis eines Lesevorganges, das als Potential an der für das Auslesen ausgewählten Bitleitung vorliegt, in Binärsignale, die weiterverarbeitet werden können, umzusetzen, können z. B. gemäß Figur 4 drei Komparatoren K1, K2, K3 eingesetzt werden. Diese Schaltung liefert zunächst ein 3-Bit-Signal. In dieser Schaltung sind alle nichtinvertierenden Eingänge dieser Komparatoren miteinander verbunden. Dieser Schaltungsknoten bildet den Eingang E der Auswerteschaltung AWS (vgl. Figur 1) und ist über eine Datenleitung mit sämtlichen weiteren Schaltern $S_{n,read}$ verbunden. Die invertierenden Eingänge der Komparatoren werden an die Bezugspotentiale $V_{ref,1}$, $V_{ref,2}$, $V_{ref,3}$ gelegt. Diese Bezugspotentiale werden so gewählt, daß je eines davon zwischen zwei aufeinanderfolgenden der aus dem Lesevorgang resultierenden Potentiale auf der betreffenden Bitleitung liegt, d. h.

$$V_{BL}(0,1) < V_{ref,1} < V_{BL}(0,0) < V_{ref,2} < V_{BL}(1,0) < V_{ref,3} < V_{BL}(1,1)$$

oder bei anderer Wahl der Potentiale

$$V_{BL}(1,0) < V_{ref,1} < V_{BL}(0,0) < V_{ref,2} < V_{BL}(0,1) < V_{ref,3} < V_{BL}(1,1).$$

In dem Beispiel mit $V_{BL}(0,0) = V_{gnd} + \beta(V_{vm} - V_{gnd})$ (β zwischen 0,3 und 0,45), $V_{BL}(1,0) = V_{vm}$, $V_{BL}(0,1) = V_{gnd}$ und $V_{BL}(1,1) = V_{pc}$ werden $V_{ref,1}$, $V_{ref,2}$, $V_{ref,3}$ vorzugsweise z. B. wie folgt gewählt:

$$V_{ref,1} \approx V_{gnd} + 0{,}5\beta(V_{vm}-V_{gnd}) \leq V_{gnd} + 0{,}225(V_{vm}-V_{gnd}),$$

$$V_{ref,2} \approx V_{gnd} + \beta(V_{vm}\text{-}V_{gnd}) + 0.5(V_{vm}\text{-}V_{gnd}\text{-}\beta(V_{vm}\text{-}V_{gnd})) = V_{gnd}$$
$$+ 0.5(1+\beta)(V_{vm}\text{-}V_{gnd}) \leq V_{gnd} + 0.725(V_{vm}\text{-}V_{gnd}),$$

$$V_{ref,3} \approx V_{gnd} + 1.25(V_{vm}\text{-}V_{gnd}) \leq V_{gnd} + 0.75(V_{DD}\text{-}V_{gnd}).$$

Auf diese Weise werden die Bezugspotentiale $V_{ref,1}$ und $V_{ref,2}$ jeweils genau zwischen die Werte $V_{BL}(0,1)$ und $V_{BL}(0,0)$ bzw. zwischen die Werte $V_{BL}(0,0)$ und $V_{BL}(1,0)$ gelegt. Bei der Wahl von $V_{ref,3}$ wurde vorausgesetzt, daß die Bedingung $V_{pc} > V_{gnd} + 1.25(V_{vm}\text{-}V_{gnd})$ erfüllt ist, vorzugsweise $V_{pc} > V_{gnd} + 1.5(V_{vm}\text{-}V_{gnd})$, was unter den Voraussetzungen $V_{pc} = V_{DD}$ und $V_{vm} = V_{gnd} + \alpha(V_{DD} - V_{gnd})$ mit $\alpha$ mindestens 0,3 und höchstens 0,6 gilt. Sollten bei anderen Ausführungen diese Bedingungen nicht erfüllt sein, was sich bei der Wahl eines Vorladepotentials $V_{pc} < V_{DD}$ oder bei der Wahl des Faktors $\alpha$ außerhalb des angegebenen Bereiches ergeben kann, dann wird $V_{ref,3}$ in jedem Fall vorzugsweise genau zwischen den größeren der Werte von $V_{BL}(0,1)$ und $V_{BL}(1,0)$ und den Wert von $V_{BL}(1,1)$ gelegt.

Als Beispiel ergibt sich für den Fall $V_{pc}=V_{DD}=V_{gnd}+5V$ und $\alpha=0,5$:

$$V_{vm}=V_{gnd}+2,5V \text{ und } \beta=0,36 \text{ und daraus}$$

$$V_{BL}(0,1)=V_{gnd}, \; V_{BL}(0,0)=V_{gnd}+0,9V, \; V_{BL}(1,0)=V_{gnd}+2,5V \text{ und}$$

$$V_{BL}(1,1)=V_{gnd}+5V \text{ sowie}$$

$$V_{ref,1}=V_{gnd}+0,45V, \; V_{ref,2}=V_{gnd}+1,7V \text{ und } V_{ref,3}=V_{gnd}+3,75V.$$

An den Ausgängen $B_1$, $B_2$, $B_3$ der Schaltung gemäß Figur 4 ergeben sich in Abhängigkeit von den Werten der den Zellen $Z_{n,k}$ und $Z_{n+1,k}$ zugeordneten booleschen Variablen $z_{n,k}$ und $z_{n+1,k}$ die in der nachstehenden Tabelle aufgeführten binären Werte $B_1$, $B_2$, $B_3$ (entsprechend einem niedrigen oder hohen Potential):

| $z_{n,k}$ | $z_{n+1,k}$ | $B_1$ | $B_2$ | $B_3$ |
|---|---|---|---|---|
| 1 | 1 | 1 | 1 | 1 |
| 1 | 0 | 1 | 1 | 0 |
| 0 | 1 | 0 | 0 | 0 |
| 0 | 0 | 1 | 0 | 0 |

Aus dieser Tabelle können die folgenden logischen Ausdrücke für den Informationsgehalt der Zellen unmittelbar abgelesen werden:

$$z_{n,k} \quad = \quad B_1 \wedge B_2 \quad \text{und}$$
$$z_{n+1,k} \quad = \quad \overline{B_1} \vee B_3 \quad = \quad \overline{B_1 \wedge \overline{B_3}}.$$

Figur 5 zeigt eine Erweiterung der Schaltung gemäß Figur 4, die an den Ausgängen $A_1$ und $A_2$ das gewünschte 2-Bit-Signal mit dem Informationsgehalt der Zellen $Z_{n,k}$ (an Ausgang $A_2$) und $Z_{n+1,k}$ (an Ausgang $A_1$) liefert. Dabei werden die logischen Ausdrucke für $z_{n,k}$ und $z_{n+1,k}$ entsprechend den vorstehenden Gleichungen mit Hilfe logischer Gatter erzeugt. Das Signal $z_{n+1,k}$ wird mit Hilfe des NAND-Gatters NAND1 erzeugt. Beim Komparator K3 sind gegenüber der Schaltung der Figur 4 die Anschlüsse des nichtinvertierenden und des invertierenden Einganges miteinander vertauscht worden. An dem Eingang dieses Komparators K3 und daher auch an einem der beiden Eingänge des NAND-Gatters NAND1 steht daher direkt das benötigte Signal $\overline{B_3}$ zur Verfügung. $z_{n,k}$ wird durch eine UND-Verknüpfung der Signale $B_1$ und $B_2$ mit Hilfe des AND-Gatters AND1 realisiert.

Der Lesevorgang wurde im Zusammenhang mit dem zuvor beschriebenen Ausführungsbeispiel eines erfindungsgemäßen Matrix-Speichers so dargestellt, daß das Potential $V_{wl}$ erst dann durch Schließen des Schalters $S'_{k,vwl}$ an die ausgewählte Wortleitung gelegt wird, wenn der Vorgang des Vorladens der Bitleitung auf das Potential $V_{pc}$ abgeschlossen ist, d. h. wenn der Schalter $S_{n,pc}$ geöffnet bzw. der weitere Schalter $S_{n,read}$ geschlossen wird. Statt dessen kann das Potential $V_{wl}$ auch bereits dann an die ausgewählte Wortleitung gelegt werden, wenn das Potential $V_{pc}$ an die ausgewählte Bitleitung gelegt wird. Das hat zur Folge, daß die Bitleitung nicht vollständig aufgeladen wird, falls mindestens eine Zelle, die eine logische „0" enthält, benachbart zu dieser Bitleitung in der ausgewählten Zeile vorhanden ist. Somit benötigt auch der in diesem Fall nach Abschluß des Vorladens der Bitleitung stattfindende Vorgang des Entladens der Bitleitung eine geringere Zeit. Der gesamte Lesevorgang erfolgt also in kürzerer Zeit, da der zu bewertende Wert (Pegel) des Potentials an der für das Auslesen ausgewählten Bitleitung in jedem Fall schneller erreicht wird. Der Eingang E der Auswerteschaltung AWS kann bereits während des Vorladens der ausgewählten Bitleitung mit dieser Bitleitung verbunden werden. Andere mögliche Varianten des erfindungsgemäßen Matrix-Speichers und des zugehörigen Lesevorganges ergeben sich aus der prinzipiellen Funktionsweise, wie sie anhand der Beispiele beschrieben wurde.

**Patentansprüche**

1. Matrix-Speicher mit Speicherzellen ($Z_{n,k}$), die in Zeilen und Spalten angeordnet sind,
   bei dem diese Speicherzellen zum Speichern einer logischen „0" oder „1" vorgesehen sind,
   bei dem in jeder dieser Speicherzellen, die eine logische „0" speichert, ein veränderbarer elektrischer Widerstand mit einem ersten, einem zweiten und einem dritten Anschluß angeordnet ist,
   bei dem zu einer Numerierung dieser Spalten
   jeweils alle diejenigen dieser Widerstände, die in geradzahlig numerierten Spalten angeordnet sind, so beschaffen sind, daß bei Anlegen eines ersten vorgegebenen Potentials ($V_{pc}$) an diesen ersten Anschluß, eines zweiten vorgegebenen Potentials ($V_{gnd}$) an diesen zweiten Anschluß und eines dritten vorgegebenen Potentials ($V_{wl}$) an diesen dritten Anschluß dieser Widerstand zwischen diesem ersten und diesem zweiten Anschluß so niedrig ist, daß ein Ausgleich der Potentialdifferenz zwischen diesem ersten und diesem zweiten Anschluß innerhalb einer für einen Lesevorgang vorgesehenen Zeit erfolgt, und daß bei Anlegen dieses ersten vorgegebenen Potentials an diesen ersten Anschluß, dieses zweiten vorgegebenen Potentials an diesen zweiten Anschluß und eines vierten vorgegebenen Potentials ($V_{gnd}$) an diesen dritten Anschluß dieser Widerstand zwischen diesem ersten und diesem zweiten Anschluß so hoch ist, daß die Potentialdifferenz zwischen diesem ersten Anschluß und diesem zweiten Anschluß während dieser für einen Lesevorgang vorgesehenen Zeit im wesentlichen erhalten bleibt,
   und jeweils alle diejenigen dieser Widerstände, die in ungeradzahlig numerierten Spalten angeordnet sind, so beschaffen sind, daß bei Anlegen dieses ersten vorgegebenen Potentials an diesen ersten Anschluß, eines von diesem zweiten vorgegebenen Potential verschiedenen fünften vorgegebenen Potentials ($V_{vm}$) an diesen zweiten Anschluß und dieses dritten vorgegebenen Potentials an diesen dritten Anschluß dieser Widerstand zwischen diesem ersten und diesem zweiten Anschluß so niedrig ist, daß ein Ausgleich der Potentialdifferenz zwischen diesem ersten und diesem zweiten Anschluß innerhalb einer für einen Lesevorgang vorgesehenen Zeit erfolgt, und daß bei Anlegen dieses ersten vorgegebenen Potentials an diesen ersten Anschluß, dieses fünften vorgegebenen Potentials an diesen zweiten Anschluß und dieses vierten vorgegebenen Potentials an diesen dritten Anschluß dieser Widerstand zwischen diesem ersten und diesem zweiten Anschluß so hoch ist, daß die Potentialdifferenz zwischen diesem ersten Anschluß und diesem zweiten Anschluß wahrend dieser für einen Lesevorgang vorgesehenen Zeit im wesentlichen erhalten bleibt,
   bei dem Bitleitungen ($BL_n$) vorhanden sind, die jeweils nur die ersten Anschlüsse oder jeweils nur die zweiten Anschlüsse aller derjenigen dieser Widerstände, die in jeweils einer dieser Spalten angeordnet sind, elektrisch leitend miteinander verbinden,
   bei dem zu jedem Paar aus einer ungeradzahlig numerierten Spalte und einer darauffolgenden geradzahlig numerierten Spalte eine dieser Bitleitungen alle ersten Anschlüsse derjenigen dieser Widerstände, die in den Spalten dieses Paares angeordnet sind, miteinander verbindet und zu jedem Paar aus einer geradzahlig numerierten Spalte und einer darauffolgenden ungeradzahlig numerierten Spalte eine dieser Bitleitungen alle zweiten Anschlüsse derjenigen dieser Widerstände, die in den Spalten dieses Paares angeordnet sind, miteinander verbindet,
   bei dem Wortleitungen ($WL_k$) vorhanden sind, die jeweils die dritten Anschlüsse aller derjenigen dieser Widerstände, die in jeweils einer dieser Zeilen angeordnet sind, elektrisch leitend miteinander verbinden,
   bei dem Schalter ($S_{n,pc}$, $S_{n,gnd}$, $S_{n,vm}$) vorgesehen sind, über die diese Bitleitungen derart mit diesem ersten, diesem zweiten und diesem fünften vorgegebenen Potential ($V_{pc}$, $V_{gnd}$, $V_{vm}$) verbunden werden können, daß zu jedem Paar aus einer ungeradzahlig numerierten Spalte und einer darauffolgenden geradzahlig numerierten Spalte an die ersten Anschlüsse derjenigen dieser Widerstände, die in den Spalten dieses Paares angeordnet sind, dieses erste vorgegebene Potential, an die zweiten Anschlüsse derjenigen dieser Widerstände, die in der geradzahlig numerierten Spalte dieses Paares angeordnet sind, dieses zweite vorgegebene Potential und an die zweiten Anschlüsse derjenigen dieser Widerstände, die in der ungeradzahlig numerierten Spalte dieses Paares angeordnet sind, dieses fünfte vorgegebene Potential angelegt werden kann, bei dem Schalter ($S'_{k,vwl}$, $S'_{k,gnd}$) vorgesehen sind, über die diese Wortleitungen mit diesem vierten vorgegebenen Potential verbunden werden können

7

und über die jeweils eine dieser Wortleitungen mit diesem dritten vorgegebenen Potential verbunden werden kann, und

bei dem weitere Schalter (S<sub>n,read</sub>) vorgesehen sind, mit denen jeweils eine Bitleitung, die die ersten Anschlüsse eines Teils dieser Widerstände miteinander verbindet, mit einer Auswerteschaltung (AWS) verbunden werden kann.

2. Matrix-Speicher nach Anspruch 1,
bei dem die Widerstände Feldeffekttransistoren sind, deren Drain-Anschluß der erste Anschluß, deren Source-Anschluß der zweite Anschluß und deren Gate-Anschluß der dritte Anschluß sind.

3. Matrix-Speicher nach Anspruch 2,
bei dem die Feldeffekttransistoren n-Kanal-MOSFETs sind und bei dem das dritte vorgegebene Potential mindestens im Abstand der größten Schwellenspannung der in den geradzahlig numerierten Spalten angeordneten Feldeffekttransistoren über dem zweiten vorgegebenen Potential und mindestens im Abstand der größten Schwellenspannung der in den ungeradzahlig numerierten Spalten angeordneten Feldeffekttransistoren über dem fünften vorgegebenen Potential liegt.

4. Matrix-Speicher nach Anspruch 2,
bei dem die Feldeffekttransistoren p-Kanal-MOSFETs sind und bei dem das dritte vorgegebene Potential mindestens im Abstand der größten Schwellenspannung der in den geradzahlig numerierten Spalten angeordneten Feldeffekttransistoren unter dem zweiten vorgegebenen Potential und mindestens im Abstand der größten Schwellenspannung der in den ungeradzahlig numerierten Spalten angeordneten Feldeffekttransistoren unter dem fünften vorgegebenen Potential liegt.

5. Matrix-Speicher nach einem der Ansprüche 1 bis 4,
bei dem das zweite und das vierte vorgegebene Potential oder das fünfte und das vierte vorgegebene Potential gleich einem Grundpotential (Masse) sind.

6. Matrix-Speicher nach Anspruch 5,
bei dem der Betrag der Potentialdifferenz zwischen dem zweiten und dem fünften vorgegebenen Potential mindestens das 0,3-fache und höchstens das 0,6-fache des größeren der Beträge der Potentialdifferenz zwischen dem ersten und dem zweiten vorgegebenen Potential und der Potentialdifferenz zwischen dem ersten und dem fünften vorgegebenen Potential ist.

7. Matrix-Speicher nach einem der Ansprüche 1 bis 6,
bei dem die Auswerteschaltung (AWS) drei Komparatoren (K1, K2, K3) umfaßt,
bei dem ein Eingang des ersten dieser Komparatoren (K1) mit einem ersten Bezugspotential (V<sub>ref,1</sub>), ein Eingang des zweiten dieser Komparatoren (K2) mit einem zweiten Bezugspotential (V<sub>ref,2</sub>) und ein Eingang des dritten dieser Komparatoren (K3) mit einem dritten Bezugspotential (V<sub>ref,3</sub>) verbunden sind,
bei dem die jeweils anderen Eingänge dieser Komparatoren miteinander und mit den weiteren Schaltern (S<sub>n,read</sub>) elektrisch leitend verbunden sind,
bei dem dieses erste Bezugspotential zwischen dem zweiten und demjenigen mittleren Potential liegt, das an den miteinander verbundenen ersten Anschlüssen der Widerstände in einer ungeradzahlig numerierten Spalte und der darauffolgenden geradzahlig numerierten Spalte anliegt, wenn an den zweiten Anschlüssen der Widerstände in dieser geradzahlig numerierten Spalte das zweite vorgegebene Potential, an den zweiten Anschlüssen der Widerstände in dieser ungeradzahlig numerierten Spalte das fünfte vorgegebene Potential und an den dritten Anschlüssen je mindestens eines dieser widerstände, die in dieser geradzahlig numerierten Spalte angeordnet sind, und eines dieser Widerstände, die in dieser ungeradzahlig numerierten Spalte angeordnet sind, das dritte vorgegebene Potential anliegt,
bei dem dieses zweite Bezugspotential zwischen dem fünften vorgegebenen Potential und diesem mittleren Potential liegt,
bei dem dieses dritte Bezugspotential zwischen dem ersten vorgegebenen Potential und dem zweiten vorgegebenen Potential und zwischen dem ersten vorgegebenen Potential und dem fünften vorgegebenen Potential liegt.

8. Matrix-Speicher nach Anspruch 7,
bei dem zwei logische Gatter vorgesehen sind, deren Eingänge mit den Ausgängen der Komparatoren (K1, K2, K3) derart verbunden sind, daß an den Ausgängen dieser Gatter der Inhalt je einer von zwei gleichzeitig gelesenen Speicherzellen als niedriges oder hohes Potential repräsentiert wird.

9. Matrix-Speicher nach Anspruch 8,
bei dem der invertierende Eingang des ersten Komparators (K1) mit dem ersten Bezugspotential ($V_{ref,1}$) verbunden ist,
bei dem der invertierende Eingang des zweiten Komparators (K2) mit dem zweiten Bezugspotential ($V_{ref,2}$) verbunden ist,
bei dem der nicht invertierende Eingang des dritten Komparators (K3) mit dem dritten Bezugspotential ($V_{ref,3}$) verbunden ist,
bei dem die logischen Gatter ein AND-Gatter (AND1) und ein NAND-Gatter (NAND1) sind,
bei dem die Ausgänge des ersten und des zweiten Komparators mit je einem Eingang dieses AND-Gatters verbunden sind und
bei dem die Ausgänge derjenigen Komparatoren, deren Eingänge mit dem niedrigsten und dem höchsten Bezugspotential verbunden sind, mit den Eingängen dieses NAND-Gatters verbunden sind.

FIG 1

**FIG 2**

**FIG 3**

**FIG 4**

**FIG 5**

# FIG 6

a)

b)